# EUROPEAN PATENT SPECIFICATION

(11) **EP 3 535 531 B1**
(45) Date of publication and mention of the grant of the patent: **23.09.2020**
(21) Application number: 17809061.9
(22) Date of filing: 27.10.2017
(51) Int. Cl.: F24H 1/28, F24H 9/00, F23M 9/00, F23M 9/10, H01L 35/30, H01L 35/34

(54) **FIRED HEAT EXCHANGER WITH A THERMOELECTRIC GENERATOR**
BEFEUERTER WÄRMETAUSCHER MIT EINEM THERMOELEKTRISCHEN GENERATOR
ÉCHANGEUR DE CHALEUR À COMBUSTION DOTÉ D'UN GÉNÉRATEUR THERMOÉLECTRIQUE

(30) Priority: 03.11.2016 PL 41934816
(43) Date of publication of application: 11.09.2019
(73) Proprietor: AIC Spólka Akcyjna, 81-577 Gdynia (PL)
(72) Inventor: SIEMIENCZUK, Tomasz, 80-351 Gdansk (PL); GULBINSKI, Wojciech, 80-980 Gdansk (PL)
(74) Representative: Pomianek, Grazyna
(86) International application number: PCT/PL2017/000111
(87) International publication number: WO 2018/084728

(56) References cited:
- WO-A1-99/36735
- WO-A1-2016/089233
- WO-A2-2008/061823
- US-A- 4 942 863

## Description

The invention concerns a fired heat exchanger with a thermoelectric generator, designated in particular for central heating and/or domestic water installations.

The market today expects new technical solutions and devices able to serve a growing number of functions, while at the same time getting more and more universal. Moreover, the entire industry is taking intense effort to develop new methods of generating electric energy. The majority of the micro-generating devices currently available in the market are based on principle of conversion of some form of kinetic energy to electric energy. Known are solutions employing different kinds of reciprocating engines, Stirling engines, turbines, etc. The solutions are characterised by substantial limitations resulting from the high level of their complexity which entails high production cost, as well as by low reliability and high costs related to ensure the required maintenance.

Known are thermoelectric devices employing the Seebeck effect, which enable generation of electric energy. The devices contain thermoelectric technical means where the temperature difference between specific areas enables generation of electric energy.

The current state of the art in the area of thermoelectric coatings implies that no solution has been found yet which would provide instruction on how to apply thermoelectric composites in a comprehensive manner and use them in devices. There are, however, some scientific publications which discuss specific methods of manufacturing the semiconductor components only, intended for thermocouples.
It should also be mentioned here that attempts are made to lay layers of bismuth telluride under the thermal spray method. Because of its high imprecision, however, the method proves poorly effective, and the produced systems of poor performance. Because of the open structure of the semiconductor junctions of the 'p' and 'n' type, the systems cannot be used safely.
Currently, the market is saturated only as concerns prefabricated thermocouples. Their fairly substantial limitations stem from their absolute lack of formability and their standardized sizes.
Recently, however, a new application group has been developed for the electricity generating thermocouples: they are used to generate electricity in the so-called hiking power generators. The devices employ heat energy to enable charging small receivers. Because of the size of the target market, however, and the technical solutions used one can hardly speak about industrial scale here. The heretofore experimental attempts at using prefabricated thermocouple modules do not stand any true chance of commercialization because of their production and size-related limitations. Another factor which effectively hampers the development of this specific industry branch is the high unit cost of thermocouples.

Known from GB 2 451 521 A is a portable water heater having a combustion chamber, where the heater burns fuel to ensure the source of heating. The combustion chamber is fitted with a fuelled burner and blower supplying air to the burner. The blower is fed with power from a thermoelectric generator which contains a Peltier-Seebeck device having one side hot from the heat produced by the burner and one side cold, cooled by the air supplied by the blower. The fuel is delivered to the burner gravitationally from a petrol can. The thermoelectric generator contains a set of semiconductor modules made of bismuth telluride (BI-TE) connected in series, where the modules produce electric voltage whenever a temperature difference occurs throughout the stack. The water heater does not need to be energy fed and can be used in field kitchens, on a boat, etc.

Document WO2016/089233 A1 discloses a fired exchanger intended for central heating and/or domestic water installations, fitted with an external jacket, combustion chamber, and the flame pipes fixed in the sieve bottoms.

Document WO 2008/061823 A2 discloses a structure and manufacturing process of thin, flexible thermoelectric elements to produce electricity.

The purpose of the invention is to improve the energy efficiency of heat exchangers, and in particular to provide a fired heat exchanger intended especially for central heating and/or domestic water installations, which would at the same time generate electric energy used for supplying power to additional electronic accessories or external devices, or fed back to the power grid. In addition, the purpose of the invention is to solve the problems discussed in the first paragraphs hereof by providing technical means which would overcome low efficiency of thermoelectric devices and reduce their production costs.

The purpose has been achieved by developing a heat exchanger fitted with thermoelectric technical means which employ the heat produced in the fuel burning process to generate electric energy.

A fired heat exchanger intended for central heating and/or domestic water installations, fitted with an external jacket, combustion chamber, and flame pipes fixed in an upper sieve bottom and a lower sieve bottom, according to the invention is characterised in having a thermoelectric generator, the functioning of which is based on the Seebeck effect, said thermoelectric generator, in use, is placed in thermal contact with combustion gases, and contains two semiconductor sub-layers (p, n) which do not contact each other and are interconnected in series with thin-layered conducting elements fitted with connection ends to evacuate the generated electric energy, said thin-layered conducting elements are electrically insulated on both sides with layers of an electrical insulator, wherein the thermoelectric generator takes the form of a thin thermoelectric coating applied under the Physical Vapour Deposition (PVD) technology to these elements of the heat exchanger which are in thermal contact with combustion gases, where directly on said elements of the heat exchanger, a first layer of the electric insulator is applied, on which a first layer of the thin-layered conducting element is applied with the thickness within the range from 1 µm to 5 µm, on which alternately the two semiconductor sub-layers (p, n) of a thermoelectric layer are applied where the thickness of each semiconductor sub-layer (p, n) ranges from 1 µm to 10 µm and the width of each semiconductor sub-layer (p, n) ranges from 0.1mm to 2mm, on which a second layer of the thin-layered conducting element is applied with the thickness within the range from 1 µm to 5 µm, on which a second layer of the electrical insulator is applied, the said electrical insulator is based on inorganic oxides, and the cold side of the semiconductor sub-layers (p, n) of the thermoelectric layer is to be cooled, in use, with water supplied to the heat exchanger.

Preferably, the thin-layered conducting elements are made of copper. Preferably, the electrical insulator layers are produced based on Al₂O₃ or SiO₂ or MgO.

Preferably, the thermoelectric coating is applied to the outer side surface of the combustion chamber and/or to the outer side surface of the flame pipes and/or to the bottom surface of the upper sieve bottom, and/or to the top surface of the lower sieve bottom and/or to at least one side of at least one sieve baffle through which the flame pipes run, and/or to the inner surface of the external jacket.

Preferably, the semiconductor sub-layers [p, n] of the thermoelectric layer are formed into alternating rings.

The invention enables additional production of electric energy obtained using the thermoelectric coating embedded in the exchanger. Besides heat energy, the heat exchanger, with its embedded thermoelectric coating, generates electric energy in accordance with the Seebeck effect. The advantage of the solution according to the invention lies in e.g. the absence of any movable elements, thanks to which the heat exchanger maintenance will be reduced. Moreover, thanks to the absence of any movable elements, the electric energy generation process is totally sound-free and vibration-free, which will allow installation of the device in higher number of locations, while at the same time minimizing arduousness of the device to the people living and working close to it; it will also ensure scalability of use, ranging from micro-applications to high powers, as well as scalability of production in automated production technology easy to be copied at a large scale. In addition, thanks to taking advantage of the thermoelectric effect, it is possible to generate electricity directly from heat energy, bypassing the conversion to kinetic energy, which will translate to high reliability and lower maintenance costs.

The electric energy produced can find different applications, e.g. in:
- supplying power to electrical sub-assemblies of a complete device, such as control elements or pumping systems (improving energy efficiency)
- building autonomous units independent of external power supply
- delivering energy back to the local power network (reducing the household demand for electric energy)
- delivering energy back to the power grid (micro sources, prosumer, citizen energy)

These and other characteristics of the invention will be clear from the following description of a preferential form of embodiment, given as a non-restrictive example, with reference to the attached drawings wherein:

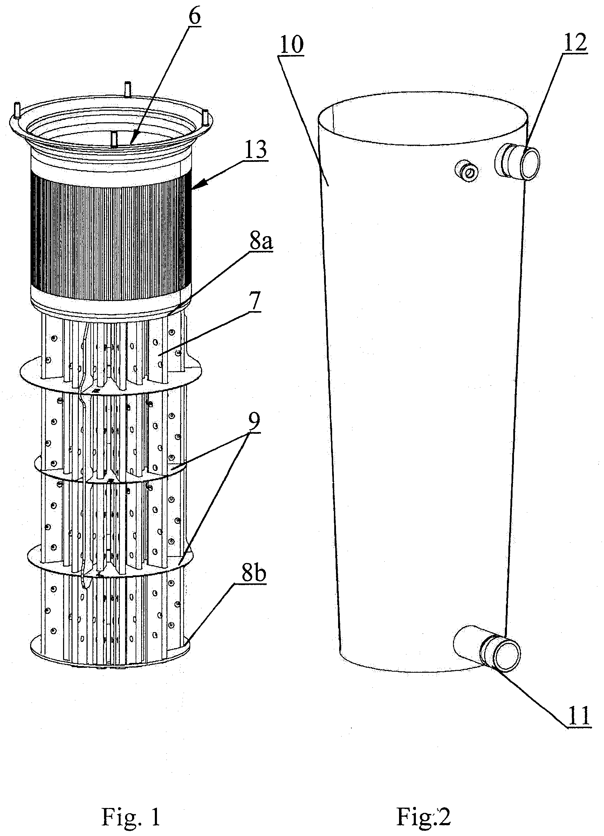

Fig. 1 shows the combustion chamber with flame pipes in perspective view;
Fig. 2 illustrates the external jacket of the heat exchanger;

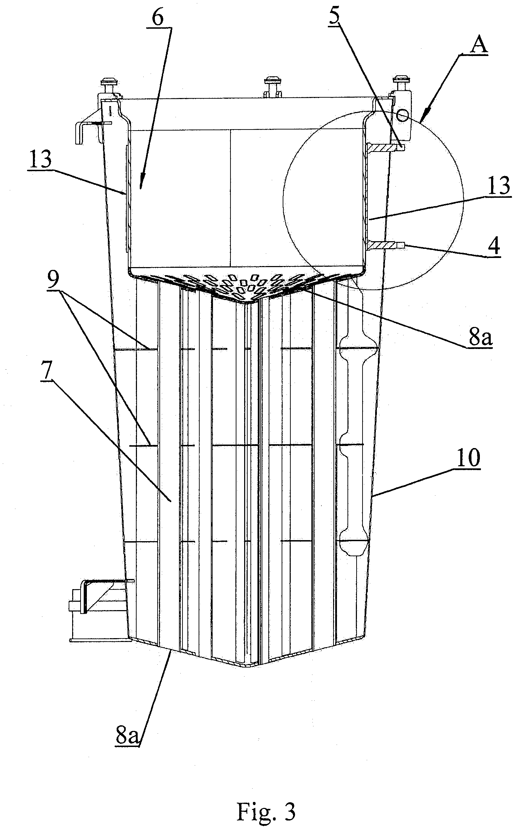

Fig. 3 shows the heat exchanger in vertical section;

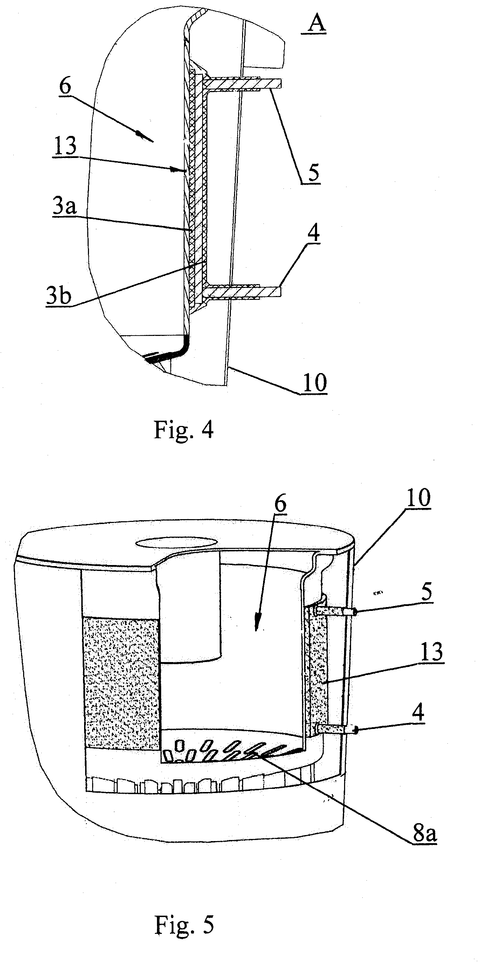

Fig. 4 depicts a fragment of the vertical section of the combustion chamber;

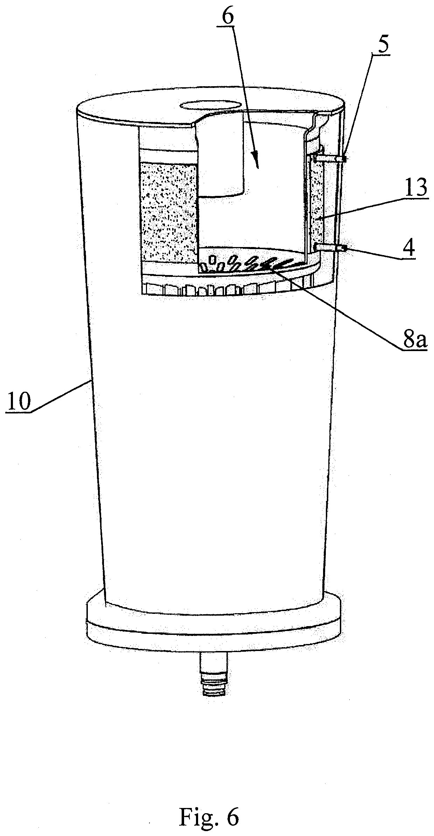

Fig. 5 shows a fragment of the heat exchanger as in Fig. 6;
Fig. 6 presents the heat exchanger in perspective view with the inside of the combustion chamber shown;

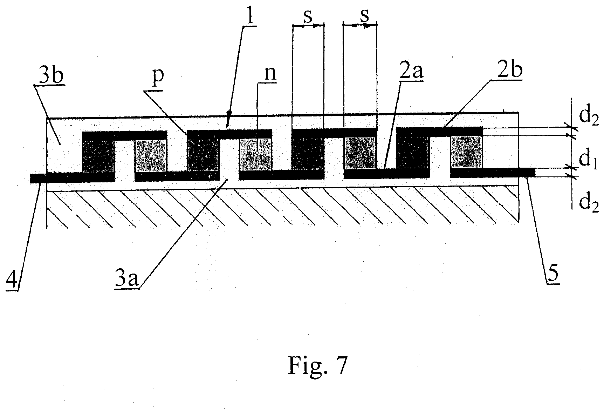

Fig. 7 illustrates the thermoelectric coating in cross-section.

A fired heat exchanger intended for central heating and/or domestic water installations has a combustion chamber 6 on top, flame pipes 7 fixed in the sieve bottoms: upper sieve bottom 8a and lower sieve bottom 8b, as well as transverse baffles 9, where the entire heat exchanger is encased in an external jacket 10 fitted with a stub pipe 11 which supplies cold water and a stub pipe 12 heated evacuating water. Applied to the outer side surface of the combustion chamber 6 under the PVD technology by e.g. evaporation, laser ablation, magnetron sputtering, filtered cathodic arc deposition, or electron beam PVD, is coating 13 which contains a thermoelectric layer 1 having two semi-conductor sub-layers [p, n] which do not contact each other, the thickness d₁ of which ranges from 1µm to 10µm, preferably amounting to 5 µm, where the sub-layers are formed into alternating rings [p, n] of the width s falling within the range from 0.1mm to 2mm, preferably amounting to 1mm, and where the rings are interconnected in series with thin-layered conducting elements 2a, 2b made of copper, the thickness d₂ of which ranges from 1 to 5µm, preferably amounting to 3µm, and where the conducting elements are fitted with end connections 4, 5 to evacuate the generated electric energy. The thermoelectric layer 1 is electrically insulated on both sides with layers 3a, 3b of electrical insulator based on inorganic oxides, particularly Al₂O₃ or SiO₂ or MgO. The cold side of the semiconductor layers [p, n] of the thermoelectric layer 1 is cooled with water supplied to the heat exchanger.

First, the process of applying the electrical insulator layer 3a should be performed in the technological chamber, thanks to which the thermoelectric layer will be electrically independent of the base. The insulating layer must be homogenous and continuous in structure. It will make it highly resistant to avalanche breakdown. Then, appropriately located thin-layered conducting elements 2a are made, which will form the basis and serve as electrical connection between the semiconductor sub-layers. There are many materials which can serve the function. Copper seems a good choice because of the ease of deposition and good conductivity. The most important components of the thermoelectric coating 13 are two semiconductor layers of the [p, n] types which can be made of the following material groups: lead telluride; tin selenide; telluride, antimony, and bismuth compounds; inorganic occlusion compounds; skutterudite; semi-Heusler compounds; silicon compounds; and germanium compounds. Thanks to the interconnection between two different semiconductor layers [p, n] achieved using a conducting layer it will be possible to achieve the flow of current whenever the composite is exposed to temperature difference. The material should be selected according to the criteria of e.g. expected performance, the ensuing thermoelectric efficiency (ZT), and the anticipated range of temperatures to which the thermoelectric coating 13 will be exposed during operation. In the next step in the process of producing a thermoelectric layer, the appropriately located thin-layered conducting elements 2 b are produced to close the electrical circuit of the thermoelectric layer 1. The last step consists in the producing of the second layer 3b of the electrical insulator.

The cold side of the semiconductor sub-layers [p, n] of the thermoelectric layer 1 is cooled with water flowing inside the external jacket 10. The thickness of the coating 13 is 50 µm or less.

In the second exemplary embodiment of the invention the coating 13 having a thermoelectric layer 1 is applied to the outer side surface of the flame pipes 7 of the heat exchanger described in example one.

In the third exemplary embodiment of the invention, the coating 13 having a thermoelectric layer 1 is applied to the bottom surface of the upper sieve bottom 8a and to the top surface of the lower sieve bottom 8b of the heat exchanger described in example one.

In the fourth exemplary embodiment of the invention, the coating 13 having a thermoelectric layer 1 is applied to both sides of the sieve baffles 9 through which the flame pipes 7 of the heat exchanger described in example one run.

In the fifth exemplary embodiment of the invention, the coating 13 having a thermoelectric layer 1 is applied to the inner surface of the external jacket 10 of the heat exchanger described in example one.

In the heat exchanger according to the invention fuel is burned in the combustion chamber 6. The thus-produced heat is received by the heated agent, i.e. water which flows through the heat exchanger. The hot side of the thermoelectric layer 1 having semiconductor layers [p, n] interconnected in series stays in thermal contact with hot combustion gases generated in the process of fuel burning in the combustion chamber 6, whereas the cold side of the same layer stays in thermal contact with the heated agent, i.e. water which flows through the heat exchanger.
In accordance with Seebeck's theory, the difference in temperature resulting therefrom triggers orderly movement of charges in the semiconductor elements [p, n] contained in the thermoelectric layer 1.
Due to the series connection between the elements, a difference of potential occurs between the outermost connection points, i.e. ends 4, 5.
The thus-produced energy can be used to supply power to electronic accessories or external devices, or delivered back to the power grid.

## Claims

1. A fired heat exchanger intended for central heating and/or domestic water installations, fitted with an external jacket, combustion chamber, and flame pipes fixed in an upper sieve bottom (8a) and a lower sieve bottom (8b), **characterised in** having a thermoelectric generator, the functioning of which is based on the Seebeck effect, said thermoelectric generator, in use, is placed in thermal contact with combustion gases, and contains two semiconductor sub-layers (p, n) which do not contact each other and are interconnected in series with thin-layered conducting elements (2a, 2b) fitted with connection ends (4, 5) to evacuate the generated electric energy, said thin-layered conducting elements (2a, 2b) are electrically insulated on both sides with layers (3a, 3b) of an electrical insulator, wherein the thermoelectric generator takes the form of a thin thermoelectric coating (13) applied under the Physical Vapour Deposition (PVD) technology to these elements of the heat exchanger which are in thermal contact with combustion gases, where directly on said elements of the heat exchanger, a first layer (3a) of the electric insulator is applied, on which a first layer of the thin-layered conducting element (2a) is applied with the thickness (d2) within the range from 1 µm to 5 µm, on which alternately the two semiconductor sub-layers (p, n) of a thermoelectric layer (1) are applied where the thickness (d1) of each semiconductor sub-layer (p, n) ranges from 1 µm to 10 µm and the width (s) of each semiconductor sub-layer (p, n) ranges from 0.1mm to 2mm, on which a second layer of the thin-layered conducting element (2b) is applied with the thickness (d2) within the range from 1 µm to 5 µm, on which a second layer (3b) of the electrical insulator is applied, the said electrical insulator (3a, 3b) is based on inorganic oxides, and the cold side of the semiconductor sub-layers (p, n) of the thermoelectric layer (1) is to be cooled, in use, with water supplied to the heat exchanger.

2. The heat exchanger according to Claim 1, **characterised in that** the thin-layered conducting elements (2a, 2b) are made of copper.

3. The heat exchanger according to Claim 1, **characterised in that** the electrical insulator layers (3a, 3b) are produced based on Al₂O₃ or SiO₂ or MgO.

4. The heat exchanger according to Claims 1 to 3, **characterised in that** the thermoelectric coating (13) is applied to the outer side surface of the combustion chamber (6).

5. The heat exchanger according to Claims 1 to 4, **characterised in that** the thermoelectric coating (13) is applied to the outer side surface of the flame pipes (7).

6. The heat exchanger according to Claims 1 to 5, **characterised in that** the thermoelectric coating (13) is applied to the bottom surface of the upper sieve bottom (8a).

7. The heat exchanger according to Claims 1 to 6, **characterised in that** the thermoelectric coating (13) is applied to the top surface of the lower sieve bottom (8b).

8. The heat exchanger according to Claims 1 to 7, **characterised in that** the thermoelectric coating (13) is applied to at least one side of at least one sieve baffle (9) through which the flame pipes (7) run.

9. The heat exchanger according to Claims 1 to 8, **characterised in that** the thermoelectric coating (13) is applied to the inner surface of the external jacket (10).

10. The heat exchanger according to Claims 1 to 9, **characterised in that** the semiconductor sub-layers (p, n) of the thermoelectric layer (1) are formed into alternating rings.

## Patentansprüche

1. Befeuerter Wärmetauscher für Zentralheizung und/oder Brauchwasseranlagen, ausgestattet mit einem Außenmantel, einer Verbrennungskammer und Flammenrohren, die am oberen Siebboden (8a) und am unteren Siebboden (8b) angeordnet sind, **dadurch gekennzeichnet, dass** er einen thermoelektrischen Generator besitzt, dessen Funktion auf dem Seebeck-Effekt beruht, wobei der oben erwähnte thermoelektrische Generator im Betrieb im thermischen Kontakt mit Gasen steht und zwei Halbleiter-Unterschichten (p, n) umfasst, die sich miteinander nicht berühren, die mit Hilfe der dünnschichtigen leitenden Elemente (2a, 2b) in Reihe miteinander geschaltet sind und die mit Anschlüssen (4, 5) für die Ableitung des erzeugten Stroms ausgestattet sind, wobei die erwähnten dünnschichtigen leitenden Elemente (2a, 2b) auf beiden Seiten mit Schichten (3a, 3b) eines elektrischen Isolators elektrisch isoliert sind, wobei der thermoelektrische Generator in Form einer dünnen thermoelektrischen Beschichtung (13) ausgebildet ist, die im Verfahren der physikalischen Gasphasenabscheidung (PVD) auf den Teilen des Wärmeaustauschers aufgebracht wird, die im thermischen Kontakt mit den Rauchgasen stehen, wobei die erste Schicht (3a) des elektrischen Isolators direkt auf den vorgenannten Teilen des Wärmetauschers aufgebracht ist, die mit der ersten Schicht des dünnschichtigen leitenden Elements (2a) mit Dicke (d₂) im Bereich von 1µm bis 5µm beschichtet sind, auf der zwei Halbleiter-Unterschichten (p, n) der thermoelektrischen Beschichtung (1) abwechselnd aufgebracht sind, wobei Dicke (d₁) jeder Halbleiter-Unterschicht (p, n) im Bereich von 1 µm bis zu 10µ und die Breite (s) jeder Halbleiterunterschicht (p, n) zwischen 0,1 mm und 2 mm liegt, und diese ist mit einer zweiten Schicht aus dem leitenden dünnschichtigen Element (2b) mit Dicke (d₂) im Bereich von 1 µm bis 5µm beschichtet, auf der die zweite Schicht (3b) des elektrischen Isolators aufgebracht ist, wobei dieser elektrische Isolator (3a, 3b) auf anorganischen Oxiden basiert und die kalte Seite der Halbleiter-Unterschichten (p, n) der thermoelektrischen Beschichtung (1) im Betrieb mit Wasser gekühlt wird, das dem Wärmetauscher zugeführt wird.

2. Wärmetauscher nach Anspruch 1, **dadurch gekennzeichnet, dass** die dünnschichtigen leitenden Elemente (2a, 2b) aus Kupfer ausgeführt sind.

3. Wärmetauscher nach Anspruch 1, **dadurch gekennzeichnet, dass** die Schichten (3a, 3b) des elektrischen Isolators auf Basis von Al₂O₃ oder SiO₂ oder MgO ausgeführt sind.

4. Wärmetauscher nach Ansprüchen 1 bis 3 **dadurch gekennzeichnet, dass** die thermoelektrische Beschichtung (13) auf der seitlichen Außenfläche der Verbrennungskammer (6) aufgebracht ist.

5. Wärmetauscher nach Ansprüchen 1 bis 4, **dadurch gekennzeichnet, dass** die thermoelektrische Beschichtung (13) auf der Außenseite der Flammrohre (7) aufgebracht ist.

6. Wärmetauscher nach Ansprüchen 1 bis 5, **dadurch gekennzeichnet, dass** die thermoelektrische Beschichtung (13) auf der unteren Oberfläche des oberen Siebbodens (8a) aufgebracht ist.

7. Wärmetauscher nach Ansprüchen 1 bis 6, **dadurch gekennzeichnet, dass** die thermoelektrische Beschichtung (13) auf der Oberseite des unteren Siebbodens (8b) aufgebracht ist.

8. Wärmetauscher nach Ansprüchen 1 bis 7, **dadurch gekennzeichnet, dass** die thermoelektrische Beschichtung (13) auf mindestens einer Seite mindestens einer Rohrwand (9) aufgebracht ist, durch die die Flammrohre (7) durchgeführt sind.

9. Wärmetauscher nach Ansprüchen 1 bis 8, **dadurch gekennzeichnet, dass** die thermoelektrische Beschichtung (13) auf der Innenfläche des Außenmantels (10) aufgebracht ist.

10. Wärmetauscher nach Ansprüchen 1 bis 9, **dadurch gekennzeichnet, dass** die Halbleiter-Unterschichten (p, n) der thermoelektrischen Beschichtung (1) in Form von abwechselnden Ringen geformt sind.

## Revendications

1. Échangeur de chaleur à combustion pour les installations de chauffage central et/ou d'eau courante, équipé d'une enveloppe extérieure, d'une chambre de combustion et de tuyaux de flamme montés dans le fond de tamis supérieur (8a) et le fond de tamis inférieur (8b), **caractérisé en ce qu'**il possède un générateur thermoélectrique, dont le fonctionnement est basé sur le phénomène Seebeck, ledit générateur thermoélectrique, pendant son fonctionnement, est mis en contact thermique avec des gaz et contient deux sous-couches semi-conductrices (p, n) n'étant pas en contact l'une avec l'autre et connectées en série avec des éléments conducteurs en couches minces (2a, 2b) équipées de bornes de connexion (4, 5) pour éliminer l'électricité produite, lesdits éléments conducteurs en couches minces (2a, 2b) étaient isolés électriquement des deux côtés avec des couches (3a, 3b) de l'isolant électrique, le générateur thermoélectrique se présentant sous la forme d'un mince revêtement thermoélectrique (13) appliqué au moyen de la technologie de dépôt physique en phase vapeur (PVD) sur les éléments de l'échangeur de chaleur qui sont en contact thermique avec les gaz d'échappement, la première couche (3a) de l'isolant électrique étant appliquée directement sur lesdits éléments de l'échangeur de chaleur, sur lesquels est appliquée la première couche de l'élément conducteur en couche mince (2a) d'une épaisseur (d₂) dans la plage de 1 µm à 5 µm, sur laquelle deux sous-couches semi-conductrices (p, n) de la couche thermoélectrique (1), dans lequel l'épaisseur (d₁) de chaque sous-couche semi-conductrice (p, n) est de 1 µm à 10 µm, et la largeur (s) de chaque sous-couche semi-conductrice (p, n) est de 0,1 mm à 2 mm, sur laquelle est appliquée la deuxième couche d'élément conducteur en couche mince (2b) d'épaisseur (d2) comprise entre 1 µm et 5 µm, sur laquelle est appliquée la deuxième couche (3b) de l'isolant électrique, ledit isolant électrique (3a, 3b) est à base d'oxydes inorganiques, et le côté froid de la sous-couche semi-conductrice (p, n) de la couche thermoélectrique (1) est refroidi pendant le fonctionnement avec de l'eau fournie à l'échangeur de chaleur.

2. Échangeur selon la revendication 1, **caractérisé en ce que** les éléments conducteurs à couche mince (2a, 2b) sont en cuivre.

3. Échangeur selon la revendication 1, **caractérisé en ce que** les couches (3a, 3b) de l'isolant électrique sont réalisées-à base d'Al₂O₃ ou SiO₂ ou MgO.

4. Échangeur selon les revendications 1 à 3, **caractérisé en ce qu'**un revêtement thermoélectrique (13) est appliqué sur la surface latérale extérieure de la chambre de combustion (6).

5. Échangeur selon les revendications 1 à 4, **caractérisé en ce qu'**un revêtement thermoélectrique (13) est appliqué sur la surface latérale extérieure des tuyaux de flamme (7).

6. Échangeur selon les revendications 1 à 5, **caractérisé en ce qu'**un revêtement thermoélectrique (13) est appliqué sur la surface inférieure du fond de tamis supérieur (8a).

7. Échangeur selon les revendications 1 à 6, **caractérisé en ce qu'**un revêtement thermoélectrique (13) est appliqué sur la surface supérieure du fond de tamis inférieur (8b).

8. Échangeur selon les revendications 1 à 7, **caractérisé en ce qu'**un revêtement thermoélectrique (13) est appliqué sur au moins un côté d'au moins la cloison à tamis (9) à travers laquelle passent les tuyaux de flamme (7).

9. Échangeur selon les revendications 1 à 8, **caractérisé en ce qu'**un revêtement thermoélectrique (13) est appliqué sur la surface intérieure de l'enveloppe extérieure (10).

10. Échangeur selon les revendications 1 à 9, **caractérisé en ce que** les sous-couches semi-conductrices (p, n) de la couche thermoélectrique (1) sont formées sous la forme d'anneaux alternés.
